**Europäisches Patentamt**

(19) **European Patent Office**

**Office européen des brevets**

(11) Numéro de publication: **0 000 856**
**B1**

(12) **FASCICULE DE BREVET EUROPEEN**

(45) Date de publication du fascicule de brevet: **16.12.81**

(21) Numéro de dépôt: **78430006.3**

(22) Date de dépôt: **20.07.78**

(51) Int. Cl.³: **H 01 L 23/36, H 01 L 23/42**

(54) Dispositif magnétique de transfert de chaleur pour microplaquette semi-conductrice.

(30) Priorité: **12.08.77 US 824197**

(43) Date de publication de la demande:
**21.02.79 Bulletin 79/4**

(45) Mention de la délivrance du brevet:
**16.12.81 Bulletin 81/50**

(84) Etats Contractants Désignés:
**DE FR GB**

(56) Documents cités:
**GB - A - 1 441 433**
**US - A - 3 706 127**

(73) Titulaire: **International Business Machines Corporation**
**Armonk, N.Y. 10504 (US)**

(72) Inventeur: **Sachar, Kenneth Selig**
**499 North Broadway White Plains**
**New York 10603 (US)**

(74) Mandataire: **Gallois, Gerard**
**COMPAGNIE IBM FRANCE Département de Propriété Industrielle**
**F-06610 - La Gaude (FR)**

Courier Press, Leamington Spa, England.

Dispositif magnétique de transfert de chaleur pour microplaquette semi-conductrice

### Domaine Technique

La présente invention concerne un dispositif magnétique de transfert de chaleur pour microplaquette semi-conductrice pouvant être utilisé dans le domaine des circuits intégrés semiconducteurs.

### Etat de la Technique Antérieure

Le transfert de chaleur entre un dispositif semi-conducteur à forte dissipation de chaleur tel qu'un SCR et son dispositif de refroidissement a soulevé dans le passé des difficultés. Le brevet GB - A - 1.441.433 propose une solution. Comme les surfaces en contact du dispositif semi-conducteur et de son dispositif de refroidissement ne peuvent présenter une planéïté parfaite, il suggère d'introduire entre ces surfaces une pâte d'aluminium, composée par exemple d'un mélange de poudre d'aluminium et d'un silicone fluide. Les deux surfaces n'ont plus besoin d'être parfaitement planes mais il suffit de les revétir de la pâte puis de les presser l'une contre l'autre et ensuite de les fixer ensemble.

### Exposé de l'invention

Au fur et à mesure que le progrès technique permet l'utilisation de quantités toujours plus importantes de dispositifs dans des microplaquettes semi-conductrices, un certain nombre de facteurs contradictoires augmentent la complexité de problème que pose l'évacuation de la chaleur engendrée dans la microplaquette, si faible que soit la dissipation de puissance d'un dispositif donné. Par exemple, lorsqu'on diminue les dimensions des dispositifs, la région de contact réservée à l'entrée et à la sortie des signaux devient totalement insuffisante pour assurer également l'évacuation de la chaleur engendrée dans la microplaquette. D'autre part, compte tenu de la résistance physique limitée offerte par les petites connexions, il n'est généralement pas possible d'employer des contacts mécaniques rigides aux fins du transfert de la chaleur en raison des contraintes excessives qui pourraient résulter d'une incompatibilité entre les coefficients de dilatation thermique.

Selon la présente invention, l'emploi d'un aimant lié thermiquement à un dispositif de refroidissement de grandes dimensions permet d'évacuer la chaleur engendrée dans la microplaquette grâce à l'emploi d'un fluide magnétique que le flux émanant de l'aimant permet de maintenir en place et dont il définit la forme, ce fluide recouvrant une partie importante de la face arrière de la microplaquette qui ne comporte pas de contacts électriques pour l'entrie et la sortie de signaux électriques. Ce fluide autorise un transfert de chaleur par conduction et par convection, et permet de procéder au remplacement et aux réparations de la microplaquette. Cela permet aux différents éléments de se déplacer les uns par rapport aux autres ce qui résout les problèmes posés par les coefficients de dilatation thermique différents. Dans le même temps l'invention permet d'obtenir un transfert maximum de chaleur du fait que la quantité de fluide magnétique maintenue par l'aimant est plus importante que ne le permettrait la simple viscosité.

D'autres objects, caractéristiques et avantages de la présente invention ressortiront mieux de l'exposé qui suit, fait en référence aux dessins annexés à ce texte, qui représentent un mode de réalisation préféré de celle-ci; toutes modifications de forme on de détail pouvant être apportée par l'homme de l'art ne sortant pas du cadre de la présente invention.

### Brève description des dessins

La figure 1 représente le dispositif magnétique de refroidissement de la présente invention.

La figure 2 est une coupe de la figure 1 et montre les détails du flux magnétique engendré par l'aimant.

Lorsque des microplaquettes semi-conductrices sont montées sur un substrat qui porte généralement les conducteurs requis pour communiquer avec les autres pièces du dispositif dont la microplaquette fait partie, cette dernière comporte un certain nombre de contacts portant des courants électriques. Afin de gagner de la place et d'éviter toute déperdition de la vitesse des signaux, ces contacts sont généralement si petits qu'ils ne permettent pas de dissiper la chaleur engendrée par les différents éléments actifs de la microplaquette. Outre les considérations afférentes à la surface occupée et à la réponse aux signaux, on peut se trouver en présence d'incompatibilités entre coefficients de dilatation thermique qui ont pour effet de limiter la possibilité d'augmenter les dimensions physiques des contacts. Selon la présente invention, un fluide magnétique est appliqué sur la face arrière de la microplaquette. La forme adoptée par ce fluide et sa circulation thermique sont déterminés par le flux engendré par un aimant lié thermiquement à un dispositif de refroidissement de grandes dimensions.

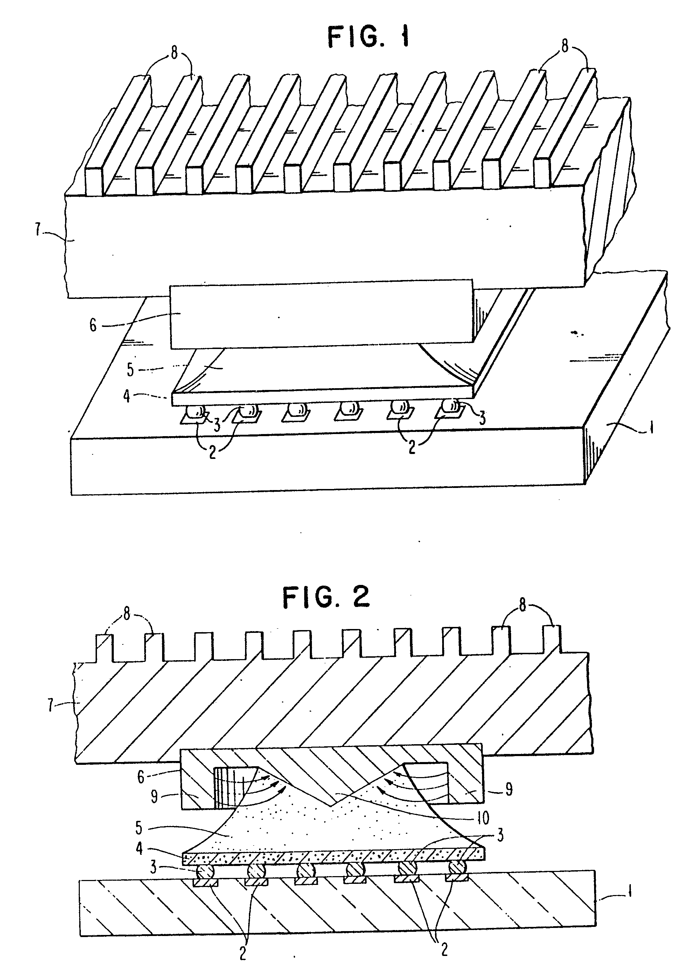

On a représenté sur la figure 1 un substrat 1 qui peut être composé d'une ou plusieurs couches isolantes contenant des conducteurs et des contacts 2 reliés à des contacts correspondants sur une microplaquette 4 au moyen de connexions 3. Les connexions représentées sont réalisées par soudure par refusion, technique dans laquelle la tension de surface d'une quantité de soudure dont la surface est limitée par les dimensions du contacts soulève la microplaquette au-dessus du substrat tout en fournissant une connexion électrique. Une autre technique bien connue de connexion avec une microplaquette consiste à assurer la liaison des conducteurs au moyen d'un cadre de montage. Cette dernière technique n'est pas représentée, mais il est évident que son principe, de même que celui de la technique précédemment mentionnée, ou de toute autre technique analogue, fait appel à l'emploi de connexions d'assez faibles dimensions, qui sont fonction de la place disponible, de la capacité de réponse aux signaux, et de la compatibilité entre coefficients de dilatation thermique, si bien qu'il est de plus en plus difficile d'augmenter les dimensions des différentes connexions de telle sorte qu'elles puissent conduire la chaleur engendrée dans la microplaquette.

Selon la présente invention, un fluide magnétique 5 est appliqué sur la face arrière de la microplaquette 4. Ce fluide, dont il existe différents types connus, se compose d'un véhicule contenant des particules magnétiques en suspension. La viscosité de ce fluide est telle qu'il ne coulera pas au-delà des bords de la microplaquette, et du fait de la présence des particules magnétiques qui se trouvent en suspension dans le fluide, la forme de ce dernier peut être modifiée par un flux magnétique. Un fluide disponible dans le commerce est commercialisé par la firme Ferro Fluidics Corporation. Le fluide doit rester stable à la température de fonctionnement de la microplaquette. Un aimant 6, qui, dans un but de simplicité, est de préférence un aimant permanent, est à son tour lié thermiquement, généralement par contact direct avec un dispositif de refroidissement 7 qui, sur la figure, comporte des ailettes 8, mais, ainsi que le comprendra l'homme de l'art, toute autre technique de refroidissement, y compris un contact direct avec d'autres fluides, peut être utilisée dans le cadre de la présente invention.

La figure 2 est une coupe de la figure 1 et montre les détails de l'aimant 6 et du fluide magnétique 5. Sur la figure 2, la microplaquette 4 est de nouveau représentée, de même que les connexions 3, réalisées par soudure par refusion, avec le substrat 1. Le fluide magnétique 5 est représenté sur la face arrière de la microplaquette 4. L'aimant 6 a une forme telle que les lignes de flux, comme le montre la figure, vont d'une région périphérique 9 vers une région centrale 10, de telle manière que, par suite du flux, le fluide 5 adopte une forme qui permet de disposer d'une quantité de fluide plus importante que celle que la viscosité permettrait normalement, augmentant ainsi le transfert de chaleur par convection et par conduction depuis la face arrière de la microplaquette vers l'aimant 6, qui est lié thermiquement au dispositif de refroidissement 7, lequel transfère à son tour la chaleur par l'intermédiaire des ailettes 8, au milieu dans lequel se trouve l'ensemble.

La configuration de la région périphérique 9 et de la partie centrale 10 de l'aimant 6 permet de réaliser deux fonctions, d'une part, de donner au fluide magnétique 5 une forme telle qu'elle permet si nécessaire de disposer d'une quantité de fluide plus grande que celle que la viscosité permettrait normalement, et, d'autre part, de maintenir le fluide en place pendant les vibrations et la dilatation thermique. La forme du fluide est telle qu'elle permet l'augmentation du transfert de chaleur par conduction et par convection. Le champ magnétique non uniforme attire généralement le fluide vers la région dans laquelle le champ magnétique est le plus intense, cette région étant en principe la partie centrale de la microplaquette. Si la qualité de fluide est correctement réglée, celui-ci assurera le scellement de la région comprise entre la face arrière de la microplaquette et l'aimant, si bien qu'on bon contact thermique sera obtenu entre la microplaquette et le dispositif de refroidissement, la connexion fluide étant indépendante de l'orientation de l'ensemble. Etant donné qu'aucun contract rigide n'existe, la microplaquette et l'aimant peuvent aisément être assemblés ou séparés, leur montage et leur réparation pouvant commodément être effectués.

La description faite ci-dessus concerne l'emploi d'un aimant et d'un fluide magnétique pour faciliter la conduction et la convection de chaleur entre la face arrière d'une microplaquette et un dispositif de refroidissement tout en maintenant en même temps un contact non rigide mais thermiquement efficace.

**Revendications**

1. Dispositif de transfert de chaleur entre une microplaquette semi-conductrice et un dispositif de refroidissement, comprenant un fluide de transfert de chaleur situé entre ceux-ci et en contact avec eux, caractérisé en ce que: le fluide est composé de particules magnétiques en suspension dans un véhicule, et le dispositif de refroidissement comporte un élément créant un champ magnétique agissant sur le fluide, les lignes de flux de ce champ ayant une configuration telle que le fluide est maintenue en glace.

2. Dispositif de transfert de chaleur selon la revendication 1 caractérisé en ce que: l'élément créant un champ magnétique est un aimant.

3. Dispositif de transfert de chaleur selon la revendication 2 caractérisé en ce que l'aimant a une forme telle qu'il crée un flux magnétique allant d'une région périphérique à une région centrale de l'aimant.

4. Dispositif de transfert de chaleur selon l'une quelconque des revendications 1 à 3 caractérisé en ce que le fluide est en contact avec la face de la microplaquette ne comportant pas des contacts électriques pour l'entrée et la sortie de signaux électriques.

5. Dispositif de transfert de chaleur selon la revendication 2 ou 3 caractérisé en ce que le fluide est en contact avec l'aimant qui est lié thermiquement avec le dispositif de refroidissement.

## Patentansprüche

1. Wärmesenke zum Übertragen von Wärme zwischen einem Halbleiterplättchen und einer Kühlvorrichtung, mit einem Wärmeübertragungsfluidum zwischen und in Kontakt mit diesen, dadurch gekennzeichnet, dass: das Fluidum aus in einem Träger schwebenden magnetischen Teilchen besteht, und die Kühlvorrichtung ein Element besitzt, das ein auf das Fluidum einwirkendes Magnetfeld hervorruft, wobei die Flusslinien dieses Feldes so ausgelegt sind, dass das Fluidum in Stellung gehalten wird.

2. Wärmesenke nach Anspruch 1, dadurch gekennzeichnet, dass: das das Magnetfeld erzeugende Element aus einem Magneten besteht.

3. Wärmesenke nach Anspruch 2, dadurch gekennzeichnet, dass der Magnet so geformt ist, dass er einen Magnetfluss zwischen einem peripherischen Bereich und einem zentralen Bereich des Magneten erzeugt.

4. Wärmesenke nach einem der Ansprüche 1 bis 3, dadurch gekennzeichnet, dass das Fluidum mit der Plättchenoberfläche, die mit keinen elektrischen Kontakten für den Eingang und Ausgang der elektrischen Signale versehen ist, in Berührung steht.

5. Wärmesenke nach Anspruch 2 oder 3, dadurch gekennzeichnet, dass das Fluidum mit dem Magneten in Berührung steht, der thermisch mit der Kühlvorrichtung verbunden ist.

## Claims

1. Heat sink for transferring heat between a semiconductor chip and a cooling device, comprising a heat transfer fluid disposed between and in contact with said chip and said device, characterized in that: the fluid consists of magnetic particles suspended in a carrier, and the cooling device is provided with an element that creates a magnetic field acting on the fluid, the pattern of the flux lines of the magnetic field being such that it keeps the fluid in place.

2. Heat sink according to claim 1, characterized in that: the element creating the magnetic field is a magnet.

3. Heat sink according to claim 2, characterized in that the shape of the magnet is such that it creates a magnetic flux from a peripheral region to a central region of the magnet.

4. Heat sink according to any one of claims 1 to 3, characterized in that the fluid is in contact with the chip surface that is not provided with electrical contacts for the input and output of electrical signals.

5. Heat sink according to claim 2 or 3, characterized in that the fluid is in contact with the magnet which is thermally connected with the cooling device.

# FIG. 1

# FIG. 2